# EUROPÄISCHE PATENTSCHRIFT

(11) **EP 4 113 128 B1**
(45) Veröffentlichungstag und Bekanntmachung des Hinweises auf die Patenterteilung: **14.05.2025**
(21) Anmeldenummer: 22000149.9
(22) Anmeldetag: 03.06.2022
(51) Int. Cl.: G01R 1/20

(54) **VERFAHREN ZUR HERSTELLUNG EINER VORRICHTUNG ZUR MESSUNG VON STROMSTÄRKEN UND VORRICHTUNG ZUR MESSUNG VON STROMSTÄRKEN**
DEVICE FOR MEASURING CURRENT INTENSITIES AND METHOD FOR MANUFACTURING A DEVICE FOR MEASURING CURRENT INTENSITIES
PROCÉDÉ DE FABRICATION D'UN DISPOSITIF DE MESURE DES NIVEAUX DE COURANT ET DISPOSITIF DE MESURE DES NIVEAUX DE COURANT

(30) Priorität: 30.06.2021 DE 102021003365; 24.11.2021 DE 102021005839
(43) Veröffentlichungstag der Anmeldung: 04.01.2023
(73) Patentinhaber: Wieland-Werke AG, 89079 Ulm (DE)
(72) Erfinder: Thumm, Gerhard, D-89155 Erbach (DE); Vucic-Seele, Dragoslav, D-89075 Ulm (DE); Noll, Tony Robert, D-89165 Dietenheim (DE)

(56) Entgegenhaltungen:
- EP-A1- 3 929 594
- DE-B4- 102007 033 182
- DE-C- 658 916
- FR-A1- 2 544 866
- US-A1- 2015 108 965

## Beschreibung

Die Erfindung betrifft ein Verfahren zur Herstellung einer Vorrichtung zur Messung von Stromstärken und eine solche Vorrichtung.

Für die Strommessung in elektronischen Schaltungen werden Messwiderstände verwendet, die in Reihe zu dem zu überwachenden Bauteil geschaltet sind. Dabei wird die Stromstärke aus der über den als Shunt-Widerstand bezeichneten Messwiderstand abfallenden Spannung bestimmt. Die korrekte und verlässliche Messung der Stromstärke ist beispielsweise besonders wichtig in einem Batteriemanagementsystem eines Elektro- oder Hybridfahrzeugs. Eine Widerstandsanordnung, die einen solchen niederohmigen Messwiderstand mit ungefähr 10 bis 50 µOhm sowie Anschlusselemente zum Verbinden der Widerstandsanordnung mit dem Stromkreis umfasst, kann aus einem längsnahtgeschweißten Verbundmaterial hergestellt werden. Dies ist beispielsweise aus der Druckschrift EP 0 605 800 A1 bekannt. Das Verbundmaterial wird aus drei Metallbändern hergestellt, indem die einzelnen Metallbänder jeweils über eine Längsnaht miteinander durch ein Elektronenstrahl- oder Laserschweißverfahren verbunden werden.

Die über einem Messwiderstand abfallende Spannung wird über Kontaktstifte oder ähnliche Elemente, die beidseitig vom Messwiderstand auf den Anschlusselementen angeordnet sind, abgegriffen. Solche Kontaktstifte können auf den Anschlusselementen der Widerstandsanordnung aufgelötet, aufgepresst oder aufgeschweißt sein. Die Spannung wird von einer Mess- und Auswerteelektronik erfasst und weiterverarbeitet. Hierfür sind elektronische Bauteile vorgesehen, die auf einer Leiterplatte angeordnet sein können. Die Leiterplatte kann sich dabei in unmittelbarer Nähe der Widerstandsanordnung befinden.

Aus der Druckschrift DE 10 2009 031 408 A1 ist eine Widerstandsanordnung mit einem niederohmigen Strommesswiderstand bekannt. Bei dieser Widerstandsanordnung sind zum Abgriff der Spannung Anschlusskontakte vorgesehen, die durch Ausprägung und Gewindeformung in den plattenförmigen Teilstücken, die zum Anschluss der Widerstandsanordnung an den äußeren Stromkreis dienen, gebildet sind. Der Anschluss der Messleitungen zur Spannungsmessung an die Anschlusskontakte erfolgt mittels Kabelschuhen und Befestigungsschrauben.

Des Weiteren ist aus der Druckschrift US 10 163 553 B2 eine Widerstandsanordnung mit zwei plattenförmigen Elementen zum Anschluss der Widerstandsanordnung an einen äußeren Stromkreis und einem streifenförmigen Widerstandselement bekannt. Beidseitig des Widerstandselements ist in den beiden Anschlusselementen jeweils ein Loch vorhanden, in das jeweils ein Kontaktstift gesteckt wird. Die Kontaktstifte sind separate Bauteile, die eigens hergestellt und zu der Widerstandsanordnung hinzugefügt werden müssen.

Aus der nachveröffentlichten Druckschrift EP 3 929 594 A1 ist ein Verfahren bekannt, bei dem ein Kontaktstift aus dem Material der Anschlusselemente einer Widerstandsanordnung geformt wird. Der Kontaktstift erstreckt sich durch die Bohrung einer Leiterplatte hindurch und weist einen Überstand über die Leiterplatte auf. Zur Fixierung der Leiterplatte ist der Kontaktstift im Bereich seines Überstands lateral verbreitert.

Die Druckschrift DE 10 2007 033 182 A1 offenbart ein Widerstandselement mit Anschlussstücken und einem Widerstandsstück, Kontakte werden gebildet werden, indem ein Draht mit gebogenen Enden auf die Anschlussstücke aufgelegt und mit der Oberfläche der Anschlussstücke stoffschlüssig, beispielsweise durch Ultraschallschweißen, verbunden wird.

Die Druckschrift DE 658 916 offenbart ein Kontaktelement, das aus einem Kontaktstück und einem Nietröhrchen besteht. Das Kontaktstück besteht aus einem flachen, am äußeren Rand durch Stanzen oder Umbiegen abgeschrägten Teil. Das Nietröhrchen wird aus Blech gerollt.

Die Druckschrift FR 2 544 866 A1 offenbart einen Shunt-Widerstand mit einem U-förmig gebogenen Widerstandselement. An den parallel zueinander verlaufenden, freien Enden des Widerstandselements sind Anschlusselemente geformt, die massive oder hohl gebildet sein können.

Die Druckschrift US 2015/108965 A1 offenbart einen Stromsensor auf Basis eines Shunt-Widerstands. Der Stromsensor umfasst eine Widerstandsanordnung und eine Leiterplatte, auf der sich eine Spanungsmesseinrichtung befindet. Zum Verbinden der Widerstandsanordnung mit der Leiterplatte weist der Stromsensor Abgriffe auf, die seitlich an der Widerstandsanordnung angebracht sind.

Bei den aus dem Stand der Technik bekannten Vorrichtungen ist es notwendig, zusätzliche Bauteile zu verwenden, um die über dem Messwiderstand abfallende Spannung abzugreifen. Dies erfordert zusätzlichen Aufwand und Kosten. Ferner können an den Kontaktstellen der einzelnen Bauteile Kontaktspannungen auftreten, die das Spannungssignal verfälschen können.

Der Erfindung liegt die Aufgabe zugrunde, ein verbessertes, insbesondere einfacheres und kostengünstigeres Verfahren zur Herstellung einer Vorrichtung zur Messung von Stromstärken und eine solche Vorrichtung anzugeben.

Die Erfindung wird bezüglich eines Verfahrens durch die Merkmale des Anspruchs 1 und bezüglich einer Vorrichtung durch die Merkmale des Anspruchs 9 wiedergegeben. Die weiteren, rückbezogenen Ansprüche betreffen vorteilhafte Aus- und Weiterbildungen der Erfindung.

Die Erfindung betrifft ein Verfahren zur Herstellung einer Vorrichtung zur Messung von Stromstärken mittels einer Widerstandsanordnung, wobei das Verfahren folgende Schritte umfasst:
a) Bereitstellen einer Widerstandsanordnung umfassend mindestens zwei Anschlusselemente, durch welche eine Stromrichtung festgelegt wird, und mindestens ein in Bezug auf die Stromrichtung zwischen den Anschlusselementen angeordnetes Widerstandselement, wobei das mindestens eine Widerstandselement einerseits und die Anschlusselemente andererseits aus unterschiedlichen, elektrisch leitenden Materialien bestehen,
b) Herausformen mindestens eines Kontaktelements aus dem Material mindestens eines Anschlusselements oder aus dem Material des Widerstandselements, so dass das Kontaktelement monolithisch mit dem Anschlusselement beziehungsweise mit dem Widerstandselement verbunden ist,_wobei das Kontaktelement eine Längsachse aufweist, durch die eine axiale Richtung und eine hierzu senkrechte radiale Richtung definiert werden, und wobei das Kontaktelement so geformt wird, dass es eine von der Widerstandsanordnung abgewandte Stirnseite und einen Hohlraum aufweist, der auf der von der Widerstandsanordnung abgewandten Stirnseite des Kontaktelements offen ist,
c) Bereitstellen einer Leiterplatte, welche mindestens eine Durchgangsbohrung mit einer inneren Oberfläche aufweist, auf der sich elektrisch leitendes Material befindet,
d) Positionieren der Leiterplatte auf der Widerstandsanordnung derart, dass die Leiterplatte eine von der Widerstandsanordnung abgewandte Oberseite aufweist und dass das mindestens eine Kontaktelement in die Durchgangsbohrung zumindest hineinragt,
e) Aufweiten des Kontaktelements in radialer Richtung mittels eines Aufweitmittels, das in axialer Richtung in den Hohlraum des Kontaktelements bis in den Bereich der Durchgangsbohrung der Leiterplatte_eingeführt wird, so dass eine elektrisch leitende Verbindung zwischen dem Kontaktelement und dem elektrisch leitenden Material auf der inneren Oberfläche der Durchgangsbohrung hergestellt wird.

Unter der Messung von Stromstärken wird auch die Messung der Stärke eines zeitlich sich möglicherweise verändernden elektrischen Stroms verstanden. Die vorstehend beschriebene Widerstandsanordnung kann einen Shunt-Widerstand mit einem Widerstand von 10 bis 50 µOhm als Widerstandselement umfassen. Sowohl das Widerstandselement als auch die Anschlusselemente bestehen aus elektrisch leitenden Materialien. Dabei ist der spezifische elektrische Widerstand des Materials des Widerstandselements deutlich größer, typischerweise mindestens einen Faktor 10 größer als der spezifische elektrische Widerstand des Materials der Anschlusselemente. Andererseits ist der Betrag des Widerstands-Temperaturkoeffizienten des Materials der Anschlusselemente sehr viel größer, typischerweise mindestens einen Faktor 80 größer als der Betrag des Widerstands-Temperaturkoeffizienten des Materials des Widerstandselements. Üblicherweise beträgt der Widerstands-Temperaturkoeffizient des Materials des Widerstandselements weniger als ±5·10⁻⁵ 1/K, während der Widerstands-Temperaturkoeffizient des Materials der Anschlusselemente ungefähr ±4·10⁻³ 1/K beträgt. Die Anschlusselemente der Widerstandsanordnung können insbesondere aus Kupfer, einer bevorzugt niedriglegierten Kupferlegierung, aus Aluminium oder einer bevorzugt niedriglegierten Aluminiumlegierung bestehen oder mindestens einen dieser Werkstoffe umfassen. Das Widerstandselement kann aus einer Kupferlegierung sein, die als Widerstandslegierung üblicherweise verwendet wird.

Die Anschlusselemente können endständige Anschlusselemente der Widerstandsanordnung sein. Es ist aber auch möglich, dass mindestens ein Anschlusselement in Bezug auf einen möglichen Strompfad zwischen zwei Widerstandselementen angeordnet ist. Die Widerstandsanordnung kann in planarer Anordnung ausgebildet sein. Dabei sind die Anschlusselemente und das mindestens eine Widerstandselement als platten- oder streifenförmige Elemente gebildet und in einer Ebene nebeneinander, bevorzugt in einer Reihe, angeordnet. Die Dicke des Widerstandselements beziehungsweise der Widerstandselemente kann dabei beliebig sein. Üblicherweise ist sie aber nicht größer als die Dicke der Anschlusselemente.

Unter Kontaktelement wird ein Werkstoffvorsprung verstanden, der sich über die sonst unverformte Oberfläche eines Anschlusselements oder des Widerstandselements erhebt. Das Formen des Kontaktelements erfolgt durch Verlagern von Material eines Anschlusselements beziehungsweise von Material des Widerstandselements im Wesentlichen in Richtung senkrecht zur Oberfläche des Anschlusselements beziehungsweise des Widerstandselements. Die Richtung, in der das Material verlagert wird, definiert eine axiale Richtung, die parallel zur Längsachse des Kontaktelements ist, und eine hierzu senkrechte, radiale Richtung. Das Kontaktelement wird so geformt, dass es eine von der Widerstandsanordnung abgewandte Stirnseite und einen Hohlraum aufweist, der auf der von der Widerstandsanordnung abgewandten Stirnseite des Kontaktelements offen ist. Das Kontaktelement ist also zumindest teilweise hohl und der Hohlraum erstreckt sich von der Stirnseite des Kontaktelements ausgehend in axialer Richtung in das Kontaktelement hinein. In radialer Richtung wird der Hohlraum durch eine umlaufende, geschlossene Wand aus verlagertem Material eines Anschlusselements beziehungsweise des Widerstandselements begrenzt. Das Kontaktelement weist in diesem Bereich also die Form einer Hülse auf, die zumindest auf einer Seite offen ist. Bevorzugt ist der Hohlraum auf der diametral gegenüberliegenden Seite geschlossen, so dass das Kontaktelement in diesem Bereich eine Form ähnlich einem Becher hat. Die Höhe des Kontaktelements beträgt mindestens 0,5 mm, bevorzugt mindestens 1 mm.

Die äußere Form des Kontaktelements kann beliebig sein, bevorzugt kreisförmig, rechteckig, quadratisch oder sechseckig. Bevorzugt hat das Kontaktelement im Bereich des Hohlraums einen kreisringförmigen Querschnitt. Form und/oder Größe des Querschnitts des Kontaktelements können konstant sein oder sich entlang der Längsachse des Kontaktelements stetig oder unstetig verändern. Beispielsweise kann das Kontaktelement eine leicht konische Kontur, also eine Kontur mit - bezogen auf die Oberfläche des Anschlusselements beziehungsweise des Widerstandselements - leicht geneigten Begrenzungsflächen aufweisen. Ferner kann das Kontaktelement so geformt werden, dass es einen Absatz aufweist. Unter einem Absatz wird eine unstetige, also sprungartige Veränderung der Querschnittsform und/oder der Querschnittsgröße des Kontaktelements verstanden. Der Absatz kann als Auflage für eine Leiterplatte dienen.

Das Kontaktelement kann, bevorzugt zusammen mit einem weiteren Kontaktelement, als Spannungsabgriff zur Messung der über dem Widerstandselement abfallenden elektrischen Spannung verwendet werden. Wenn das Kontaktelement aus dem Material des Widerstandselements geformt wird, kann es als Spannungsabgriff zur Messung der über einem Teil des Widerstandselements abfallenden elektrischen Spannung verwendet werden. Alternativ kann das Kontaktelement auch zur Erdung der Widerstandsanordnung dienen. Bevorzugt werden in allen Anschlusselementen der Widerstandsanordnung ein oder mehrere solcher Kontaktelemente geformt. Dabei werden die Kontaktelemente, die zur Spannungsmessung dienen, möglichst nahe an dem Widerstandselement positioniert, an dem der Spannungsabfall ermittelt werden soll.

Im Rahmen der vorliegenden Erfindung wird unter einer Leiterplatte ein flaches, platten- oder streifenförmiges Bauteil verstanden, das geeignet ist, elektrische Signale in einem elektrisch leitenden Material zu leiten. Ein flaches Bauteil ist platten- oder streifenförmig, wenn zwei gegenüberliegende Flächen des Bauteils zueinander planparallel sind. Der Abstand dieser beiden Flächen definiert die Dicke des Bauteils. Eine Leiterplatte kann beispielsweise ein Metallstreifen sein oder eine Platte aus einem nicht-leitenden Material, auf deren Oberfläche Leiterbahnen aufgebracht sind. Derartige Platten sind unter dem Begriff "printed circuit board" bekannt. Die Leiterplatte weist mindestens eine Durchgangsbohrung mit einer inneren Oberfläche auf, auf der sich elektrisch leitendes Material befindet. Dies schließt auch den Fall ein, dass die Leiterplatte ein Metallstreifen oder ein Metallplättchen ist, so dass sich auf der inneren Oberfläche der Durchgangsbohrung in inhärenter Weise elektrisch leitendes Material befindet. Falls die Leiterplatte eine Platte aus nicht-leitendem Material ist, auf deren Oberfläche Leiterbahnen aufgebracht sind, kann das elektrisch leitende Material auf der inneren Oberfläche der Durchgangsbohrung mit einer Leiterbahn verbunden sein, die bevorzugt auf der von der Widerstandsanordnung abgewandten Seite der Leiterplatte angeordnet ist. Ferner können auf einer solchen Leiterplatte elektrische Bauteile angeordnet sein, die zur Messung und Auswertung von elektrischen Signalen dienen. Mit dem Begriff Durchgangsbohrung wird eine Aussparung in der Leiterplatte bezeichnet, die sich über die gesamte Dicke der Leiterplatte erstreckt. Die Durchgangsbohrung kann eine zylindrische Form haben. Alternativ ist auch eine konische Form möglich.

Die Leiterplatte wird auf der Widerstandsanordnung in einer Weise positioniert, dass das mindestens eine Kontaktelement in die Durchgangsbohrung zumindest hineinragt. Die Leiterplatte wird dabei im Wesentlichen planparallel zur Widerstandsanordnung positioniert, so dass die Leiterplatte eine von der Widerstandsanordnung abgewandte Oberseite und eine der Widerstandsanordnung zugewandte Unterseite aufweist. Zwischen der Leiterplatte und der Widerstandsanordnung kann ein Abstand sein. Es ist jedoch auch möglich, dass die Leiterplatte direkt auf der Widerstandsanordnung aufliegt. Das Kontaktelement sollte mindestens bis zur Hälfte der Dicke der Leiterplatte, bevorzugt mindestens bis zu 70 % der Dicke der Leiterplatte, in die Durchgangsbohrung der Leiterplatte hineinragen.

Anschließend wird das Kontaktelement in radialer Richtung mittels eines geeigneten Aufweitmittels aufgeweitet. Hierzu wird das Aufweitmittel ausgehend von der Oberseite der Leiterplatte in axialer Richtung in den Hohlraum des Kontaktelements eingeführt. Das Aufweitmittel ist so ausgebildet, dass es das Kontaktelement im Bereich des Hohlraums in radialer Richtung aufweiten kann. Hierzu wird das Material des Kontaktelements, das den Hohlraum in radialer Richtung begrenzt, in radialer Richtung soweit nach Außen verlagert, dass es mit der inneren Oberfläche der Durchgangsbohrung der Leiterplatte in Kontakt kommt. Auf diese Weise wird eine elektrisch leitende Verbindung zwischen dem Kontaktelement und dem elektrisch leitenden Material auf der inneren Oberfläche der Durchgangsbohrung hergestellt. Die durch das Aufweiten bewirkte Vergrößerung der Außenabmessung des Kontaktelements beträgt bevorzugt zwischen 2 % und 15 % seiner Außenabmessung vor dem Aufweiten. Durch das Aufweiten wird ferner die Wanddicke des Kontaktelements reduziert. Eine Reduktion um mindestens 20 % der ursprünglichen Wanddicke ist günstig. Das Aufweitmittel kann ein geeignetes Werkzeug sein, das nach dem Aufweiten wieder aus dem Hohlraum des Kontaktelements entfernt wird.

Der Vorteil des beschriebenen Verfahrens besteht darin, dass zur Herstellung der Verbindung zwischen Widerstandsanordnung und Leiterplatte keine zusätzlichen Bauteile und/oder Materialien benötigt werden. Weil das Kontaktelement direkt aus dem Material eines Anschlusselements oder des Widerstandselements geformt wird, ist es nicht erforderlich, das Kontaktelement separat auf der Widerstandsanordnung oder auf der Leiterplatte zu montieren. Es entfallen die hierfür notwendigen Arbeitsschritte und die benötigten Materialien, wie beispielsweise Lot. Mehrere Kontaktelemente können gleichzeitig geformt werden.

Durch die monolithische Verbindung zwischen Kontaktelement und Anschlusselement beziehungsweise zwischen Kontaktelement und Widerstandselement werden unerwünschte Kontaktspannungen, die eine Messung verfälschen können, vermieden.

Ein besonders vorteilhafter Aspekt des vorgeschlagenen Verfahrens ist das radiale Aufweiten des Kontaktelements durch ein geeignetes Aufweitmittel. Weil das Aufweitmittel in den Hohlraum des Kontaktelements eingeführt wird, erfolgt die Verbindung zwischen Kontaktelement und Leiterplatte im Wesentlichen im Bereich der Durchgangsbohrung. Somit ist es nicht erforderlich, dass das Kontaktelement über die Leiterplatte hinausragt, also einen Überstand über die Oberseite der Leiterplatte aufweist. Zur Formung des Kontaktelements muss das Material des Anschlusselements oder des Widerstandselements somit nur in einem geringen Maß verformt werden. Die notwendigen Kräfte sind gering. Dies ist vorteilhaft hinsichtlich der Werkzeugstandzeit und der Prozessgeschwindigkeit. Besonders vorteilhaft anwendbar ist das vorgeschlagene Verfahren, wenn ein oder mehrere Kontaktelemente aus dem Widerstandselement geformt werden sollen. Das Material des Widerstandselements ist üblicherweise schwerer unformbar als das Material der Anschlusselemente. Je weniger weit es verformt werden muss, desto einfacher ist der Prozess.

Das Aufweitmittel kann auch ein Körper sein, der dauerhaft im Hohlraum des Kontaktelements verbleibt. Ein solcher Körper kann beispielsweise ein Stopfen oder ein Niet sein. Durch einen solchen Körper wird ein besonders verlässlicher und dauerhafter Kontakt zwischen dem Kontaktelement und der inneren Oberfläche der Durchgangsbohrung der Leiterplatte hergestellt.

Wird die Widerstandsanordnung hergestellt, indem sie aus einem längsnahtgeschweißten, bandförmigen Verbundmaterial abgelängt wird, dann können die Kontaktelemente bevorzugt gleichzeitig mit dem Ablängen des Verbundmaterials geformt werden. Die Schritte a) und b) des Verfahrens erfolgen in diesem Fall also gleichzeitig. Ein separater, zusätzlicher Arbeitsschritt für das Formen der Kontaktelemente ist somit nicht notwendig. Das Verfahren ist somit schneller und kostengünstiger, als wenn die Kontaktelemente erst nach dem Ablängen des Verbundmaterials geformt werden. Ferner wird auf diese Weise eine hohe Positionsgenauigkeit der Kontaktelemente erreicht.

Im Rahmen einer Ausführungsform der Erfindung kann das Aufweitmittel so gestaltet sein, dass das Aufweiten des Kontaktelements durch das Einführen des Aufweitmittels erfolgt. Das Kontaktelement wird also bereits während des Einführens des Aufweitmittels in den Hohlraum in radialer Richtung aufgeweitet. Hierzu weist das Aufweitmittel zumindest teilweise eine konische Außenkontur auf. Diese Außenkontur führt zu einer radialen Verlagerung des Materials des Kontaktelements, wenn das Aufweitmittel in den Hohlraum eingeführt wird. Damit werden kurze Bearbeitungszeiten ermöglicht.

Im Rahmen einer hierzu alternativen Ausführungsform der Erfindung kann das Aufweitmittel so gestaltet sein, dass das Aufweiten des Kontaktelements nach dem Einführen des Aufweitmittels erfolgt. Das Kontaktelement wird also im Wesentlichen erst nach dem Einführen des Aufweitmittels in den Hohlraum in radialer Richtung aufgeweitet. Hierzu weist das Aufweitmittel einen Abschnitt auf, dessen Außendurchmesser kleiner als der Innendurchmesser des Hohlraums ist. Das Einführen dieses Abschnitts des Aufweitmittels in den Hohlraum erfolgt dann ohne signifikanten Widerstand und somit auch ohne ungewollte Verformung des Kontaktelements. Nach dem Einführen des Aufweitmittels erfolgt das radiale Aufweiten des Kontaktelements mittels eines geeigneten Mechanismus. Falls das Aufweitmittel ein Werkzeug ist, kann dies beispielsweise durch ein Spreizen des Werkzeugs, durch eine exzentrische Rotation des Werkzeugs oder durch elektromagnetische Kräfte erfolgen

Im Rahmen einer bevorzugten Ausführungsform der Erfindung kann durch das Aufweiten in Verfahrensschritt e) auch gleichzeitig eine kraftschlüssige Verbindung zwischen der inneren Oberfläche der Durchgangsbohrung der Leiterplatte und dem Kontaktelement hergestellt werden. Hierzu erfolgt das Aufweiten des Kontaktelements in einem Ausmaß, dass das Material an die innere Oberfläche der Durchgangsbohrung der Leiterplatte so stark angedrückt wird, dass eine Presspassung ausgebildet wird. Die Wanddicke des Kontaktelements wird dabei bevorzugt um mindestens 40 % reduziert. Durch die Ausbildung der Presspassung können andere Mittel zur mechanischen Fixierung der Leiterplatte auf der Widerstandsanordnung eingespart werden.

Im Rahmen einer speziellen Ausgestaltung dieser Ausführungsform der Erfindung kann durch das Aufweiten in Verfahrensschritt e) auch gleichzeitig eine formschlüssige Verbindung zwischen der inneren Oberfläche der Durchgangsbohrung der Leiterplatte und dem Kontaktelement hergestellt werden. Beispielsweise kann die Durchgangsbohrung der Leiterplatte eine konische Form haben und so gestaltet sein, dass sich der Innendurchmesser von der Unterseite der Leiterplatte zu deren Oberseite hin vergrößert. Bei Verwendung eines Aufweitmittels mit angepasster konischer Außenkontur führt das Aufweiten des Kontaktelements zu einer formschlüssigen Verbindung. Eine solche Verbindung stellt eine besonders sichere Art der Verbindung dar.

Im Rahmen einer bevorzugten Ausführungsform der Erfindung kann das Kontaktelement eine Höhe aufweisen, die so gewählt ist, dass nach dem Positionieren der Leiterplatte die von der Widerstandsanordnung abgewandte Stirnseite des Kontaktelements sich innerhalb der Durchgangsbohrung der Leiterplatte befindet oder mit der Oberseite der Leiterplatte bündig abschließt. Die Höhe bezeichnet dabei die Erstreckung des Kontaktelements in axialer Richtung gemessen ab der unverformten Oberfläche des Anschlusselements beziehungsweise des Widerstandselements. Die Höhe ist also so bemessen, dass die Eindringtiefe des Kontaktelements in die Durchgangsbohrung der Leiterplatte maximal gleich der Dicke der Leiterplatte ist. Mit anderen Worten, das Kontaktelement weist bei dieser Ausführungsform keinen Überstand über die Oberseite der Leiterplatte auf. Ein Kontaktelement von so geringer Höhe lässt sich besonders günstig formen. Im Rahmen einer speziellen Ausgestaltung dieser Ausführungsform der Erfindung kann die Eindringtiefe des Kontaktelements in die Durchgangsbohrung der Leiterplatte 80 bis 100 % der Dicke der Leiterplatte betragen. Dies stellt ein Optimum zwischen dem notwendigen Aufwand bei der Formung des Kontaktelements und der Qualität des Kontakts zwischen Kontaktelement und Leiterplatte dar.

Im Rahmen einer weiteren Ausführungsform der Erfindung kann das Formen des Kontaktelements in Verfahrensschritt b) durch einen Prägeschritt oder durch Fließpressen erfolgen. Prägen und Fließpressen eignen sich besonders zur Formung von monolithisch mit dem Material der Anschlusselemente oder des Widerstandselements verbundenen Kontaktelementen, die sich im Wesentlichen senkrecht zur Oberfläche der Anschlusselemente beziehungsweise des Widerstandselements erstrecken. Das Formen des Materials erfolgt dabei mittels eines Stempels und einer geeigneten Negativform.

Im Rahmen einer speziellen Ausgestaltung dieser Ausführungsform der Erfindung kann zur Formgebung des Kontaktelements eine Negativform mit mindestens einer der äußeren Kontur des Kontaktelements entsprechenden Aussparung und mindestens einem in der Aussparung positionierten Innenwerkzeug zur Formung des Hohlraums verwendet werden, wobei während Verfahrensschritt b) das Innenwerkzeug in Richtung der Längsachse des Kontaktelements relativ zur Aussparung bewegt wird. Dies hat sich als umformtechnisch besonders günstige Prozessführung erwiesen, so dass Kontaktelemente mit einer großen Höhe erzeugt werden können.

Im Rahmen einer weiteren speziellen Ausgestaltung der Erfindung kann das Aufweiten des Kontaktelements in Verfahrensschritt e) durch Erwärmen des Materials des Kontaktelements mittels Ultraschall oder mittels eines Lasers unterstützt werden. Das Material des Kontaktelements ist aufgrund der Verformung in Verfahrensschritt b) verfestigt und hart. Dies ist für die nachfolgende Verformung in Schritt e) hinderlich. Durch den Eintrag von Wärme mittels eines Lasers oder mittels Ultraschall kann das Material des Kontaktelements soweit erwärmt werden, dass es sich zumindest teilweise entfestigt, also weicher wird. Das Verformen in Schritt e) ist dann leichter möglich.

Hinsichtlich weiterer technischer Merkmale und Vorteile des erfindungsgemäßen Verfahrens wird hiermit explizit auf die nachstehenden Erläuterungen im Zusammenhang mit einer Vorrichtung zur Messung von Stromstärken sowie auf die Figuren und die Figurenbeschreibung verwiesen.

Ein weiterer Aspekt der Erfindung betrifft eine Vorrichtung zur Messung von Stromstärken. Hierunter wird auch die Messung der Stärke eines zeitlich sich möglicherweise verändernden elektrischen Stroms verstanden. Die Vorrichtung umfasst eine Widerstandsanordnung und eine mit der Widerstandsanordnung mechanisch und elektrisch verbundene Leiterplatte. Die Widerstandsanordnung umfasst mindestens zwei Anschlusselemente, die eine Stromrichtung definieren, und mindestens ein in Bezug auf die Stromrichtung zwischen den Anschlusselementen angeordnetes Widerstandselement, wobei das mindestens eine Widerstandselement einerseits und die Anschlusselemente andererseits aus unterschiedlichen, elektrisch leitenden Materialien bestehen. Die Leiterplatte weist mindestens eine Durchgangsbohrung mit einer inneren Oberfläche auf, auf der sich elektrisch leitendes Material befindet. Die Widerstandsanordnung weist mindestens ein Kontaktelement mit einer Längsachse auf, das monolithisch mit einem der Anschlusselemente verbunden und aus dem Material des Anschlusselements herausgearbeitet ist, oder das monolithisch mit dem Widerstandselement verbunden und aus dem Material des Widerstandselements herausgearbeitet ist. Durch dieses Kontaktelement ist die Widerstandsanordnung mit der Leiterplatte elektrisch leitend und mechanisch verbunden, indem das Kontaktelement in die Durchgangsbohrung der Leiterplatte zumindest hineinragt und mit dem elektrisch leitenden Material auf der inneren Oberfläche der Durchgangsbohrung kraftschlüssig verbunden ist. Hierzu weist das Kontaktelement eine von der Widerstandsanordnung abgewandten Stirnseite und einen Hohlraum auf, der auf der von der Widerstandsanordnung abgewandten Stirnseite des Kontaktelements offen ist. Am Übergang von seiner Stirnseite zum Hohlraum weist das Kontaktelement auf seiner Innenseite eine konische Kontur auf, die sich bis in den Bereich der Durchgangsbohrung der Leiterplatte erstreckt.

Hinsichtlich der zur Beschreibung der Vorrichtung verwendeten Begriffe wird hiermit explizit auf die vorstehenden Erläuterungen der Begriffe im Zusammenhang mit der Beschreibung des Verfahrens zur Herstellung einer Vorrichtung zur Messung von Stromstärken verwiesen.

Der besondere Vorteil der beschriebenen Vorrichtung besteht darin, dass durch die monolithische Verbindung zwischen Kontaktelement und Anschlusselement beziehungsweise Widerstandselement unerwünschte Kontaktspannungen, die eine Messung verfälschen können, vermieden werden. Ferner kann die Vorrichtung kostengünstig und mit hoher Präzision hergestellt werden, denn das Kontaktelement ist unmittelbar aus dem Material des Anschlusselements oder des Widerstandselements herausgeformt. Ein besonders vorteilhafter Aspekt der beschriebenen Vorrichtung ist die kraftschlüssige Verbindung zwischen der Leiterplatte und der Widerstandsanordnung. Diese Verbindung wird durch das Kontaktelement hergestellt, welches durch einen Aufweitprozess mit der inneren Oberfläche der Durchgangsbohrung der Leiterplatte in elektrischen und mechanischen Kontakt gebracht wird. Zur Durchführung dieses Aufweitprozesses weist das Kontaktelement eine von der Widerstandsanordnung abgewandte Stirnseite und einen Hohlraum auf, der auf der von der Widerstandsanordnung abgewandten Stirnseite des Kontaktelements offen ist. Am Übergang von seiner Stirnseite zum Hohlraum weist das Kontaktelement auf seiner Innenseite_eine konische Kontur auf. Diese konische Kontur ist das Resultat des Aufweitprozesses und sie kann zur leichteren Einführung eines Aufweitmittels in den Hohlraum des Kontaktelements dienen.

Im Rahmen einer Ausführungsform der Erfindung kann das Kontaktelement eine Höhe aufweisen, die so gewählt ist, dass die von der Widerstandsanordnung abgewandte Stirnseite des Kontaktelements sich innerhalb der Durchgangsbohrung der Leiterplatte befindet oder mit der Oberseite der Leiterplatte bündig abschließt. Die Höhe bezeichnet dabei die Erstreckung des Kontaktelements in Richtung seiner Längsachse gemessen ab der unverformten Oberfläche des Anschlusselements beziehungsweise des Widerstandselements. Die Höhe ist also so bemessen, dass die Eindringtiefe des Kontaktelements in die Durchgangsbohrung der Leiterplatte maximal gleich der Dicke der Leiterplatte ist. Mit anderen Worten, das Kontaktelement weist keinen Überstand über die Oberseite der Leiterplatte auf. Ein Kontaktelement mit dieser geringen Höhe lässt sich besonders günstig formen. Im Rahmen einer speziellen Ausgestaltung dieser Ausführungsform der Erfindung kann die Eindringtiefe des Kontaktelements in die Durchgangsbohrung der Leiterplatte 80 bis 100 % der Dicke der Leiterplatte betragen. Dies stellt ein Optimum zwischen dem notwendigen Aufwand bei der Formung des Kontaktelements und der Qualität des Kontakts zwischen Kontaktelement und Leiterplatte dar.

Im Rahmen einer alternativen Ausführungsform der Erfindung kann das Kontaktelement auf der von der Widerstandsanordnung abgewandten Seite der Leiterplatte einen Überstand über die Leiterplatte aufweisen und zur Fixierung der Leiterplatte im Bereich dieses Überstands lateral verbreitert sein, bevorzugt konisch aufgeweitet sein. Durch das laterale Verbreitern, insbesondere durch konisches Aufweiten des Kontaktelements im Bereich dieses Überstands über die Leiterplatte wird die Leiterplatte in axialer Richtung des Kontaktelements, also in Richtung zum Anschlusselement der Widerstandsanordnung hin, zumindest in einer Richtung formschlüssig fixiert. Das laterale Verbreitern kann außer durch konisches Aufweiten auch durch andere Verformungen des Kontaktelements erfolgen. Beispiele hierfür sind Crimpen, Bördeln, partielles Umbiegen und Aufweiten mittels eines kugelförmigen, zylindrischen oder balligen Werkzeugs.

Im Rahmen einer besonderen Ausgestaltung dieser alternativen Ausführungsform der Erfindung kann das Kontaktelement zwischen dem Anschlusselement und der Leiterplatte einen Abschnitt mit einer konischen Außenkontur aufweisen. Der konische Abschnitt ist dabei so gewählt, dass sich die Querschnittsfläche des Kontaktelements zum Anschlusselement hin vergrößert. Der Abschnitt mit der konischen Kontur schließt unmittelbar an die Leiterplatte an. Durch die konische Außenkontur vergrößert sich die Querschnittsfläche des Kontaktelements stetig und mindestens so weit, dass diese größer als die Querschnittsfläche der Durchgangsbohrung der Leiterplatte ist. Zusammen mit dem konischen Aufweiten des Kontaktelements im Bereich seines Überstands kann somit eine form- und kraftschlüssige Fixierung der Leiterplatte sowohl in Richtung der Achse des Kontaktelements als auch senkrecht hierzu erreicht werden. Die Leiterplatte ist durch das Kontaktelement doppelt-konisch verklemmt. Diese Ausgestaltung der Erfindung ist besonders resistent gegen mechanische Belastungen wie beispielsweise Vibrationen.

Im Rahmen einer weiteren vorteilhaften Ausführungsform der Vorrichtung kann das mindestens eine Kontaktelement einen Absatz aufweisen, auf dem die Leiterplatte in einer Weise aufliegt, dass die Leiterplatte vom Anschlusselement und somit von der Widerstandsanordnung beabstandet ist. Der Abstand zwischen der Leiterplatte und der Widerstandsanordnung bewirkt eine bessere thermische Entkopplung der Leiterplatte von der Widerstandsanordnung. Die Wärme, die bei Stromfluss durch das Widerstandselement entsteht, kann in diesem Fall nicht direkt vom Widerstandselement oder von einem Anschlusselement auf die Leiterplatte übertragen werden, sondern die Wärme muss durch das Kontaktelement strömen. Aufgrund seines relativ kleinen Querschnitts stellt das Kontaktelement einen großen Wärmewiderstand dar. Der Wärmestrom von der Widerstandsanordnung zur Leiterplatte wird deshalb reduziert und die Leiterplatte bleibt auf einem niedrigeren Temperaturniveau, als wenn die Leiterplatte direkt auf einem Anschlusselement aufliegen würde. Diese Ausführungsform ist besonders dann vorteilhaft, wenn die Dicke des Widerstandselements nicht kleiner als die jeweilige Dicke der Anschlusselemente ist.

Ferner kann im Rahmen einer besonders vorteilhaften Ausführungsform der Vorrichtung vorgesehen sein, dass ein erstes Kontaktelement zwischen dem Anschlusselement und der Leiterplatte einen konischen Abschnitt aufweist, während ein zweites Kontaktelement zwischen dem Anschlusselement und der Leiterplatte einen Absatz aufweist, auf dem die Leiterplatte aufliegt. Insbesondere können beide Kontaktelemente hierbei auf der von der Widerstandsanordnung abgewandten Seite der Leiterplatte jeweils einen Überstand über die Leiterplatte aufweisen und im Bereich des Überstands lateral verbreitert sein. Der besondere Vorteil einer solchen Kombination von Kontaktelementen mit unterschiedlicher Form und Funktion ist, dass bei der überlagerten Belastung aus Vibration und Temperaturwechsel das erste Kontaktelement für eine Fixierung der Leiterplatte in lateraler Richtung sorgt, während das zweite Kontaktelement eine Fixierung der Leiterplatte in Richtung senkrecht zur Leiterplatte ermöglicht, ohne dabei eine zusätzliche Einschränkung der Bewegungsfreiheit in lateraler Richtung zu bewirken. Spannungen, die bei Änderung der Temperatur aufgrund unterschiedlicher Ausdehnung von Leiterplatte und Widerstandsanordnung entstehen können, werden somit reduziert. Die Vorrichtung ist somit besonders robust.

In vorteilhafter Ausgestaltung der Erfindung kann die Oberfläche des mindestens einen Kontaktelements eine metallische Beschichtung, insbesondere eine zinn-, silber- oder nickelhaltige Beschichtung, aufweisen. Eine solche Beschichtung verhindert Korrosion und kann somit dafür sorgen, dass der elektrische Kontakt zwischen dem Kontaktelement und dem elektrisch leitenden Material auf der inneren Oberfläche der Durchgangsbohrung über die gesamte Lebensdauer der Vorrichtung von hoher Güte ist. Die Beschichtung kann dabei vor dem Formen des Kontaktelements in Schritt b) aufgebracht worden sein oder das Kontaktelement kann in einem separaten Schritt zwischen den Verfahrensschritten b) und c) beschichtet worden sein.

Hinsichtlich weiterer technischer Merkmale und Vorteile der erfindungsgemäßen Vorrichtung wird hiermit explizit auf die Erläuterungen im Zusammenhang mit dem vorstehend beschriebenen erfindungsgemäßen Verfahren sowie auf die Figuren und die Figurenbeschreibung verwiesen.

Ausführungsbeispiele der Erfindung werden anhand der schematischen Zeichnungen näher erläutert.

Darin zeigen:
Fig. 1 eine Schrägansicht einer Widerstandsanordnung
Fig. 2 eine Seitenansicht einer Widerstandsanordnung
Fig. 3 in Schnittansicht einen Ausschnitt aus einer Widerstandsanordnung bei Abschluss von Verfahrensschritt b)
Fig. 4 in Schnittansicht einen Ausschnitt aus einer Widerstandsanordnung mit geformtem Kontaktelement
Fig. 5 in Schnittansicht einen Ausschnitt aus einer Widerstandsanordnung mit darauf positionierter Leiterplatte
Fig. 6 in Schnittansicht einen Ausschnitt aus einer Widerstandsanordnung während Verfahrensschritt e)
Fig. 7 in Schnittansicht einen Ausschnitt aus einer Widerstandsanordnung mit darauf fixierter Leiterplatte
Fig. 8 in Schnittansicht einen Ausschnitt aus einer Widerstandsanordnung mit darauf fixierter Leiterplatte und mit Kontaktelement mit Absatz
Fig. 9 in Schnittansicht einen Ausschnitt aus einer Widerstandsanordnung mit darauf fixierter Leiterplatte und mit Kontaktelement mit konischem Abschnitt

Einander entsprechende Teile sind in allen Figuren mit denselben Bezugszeichen versehen.

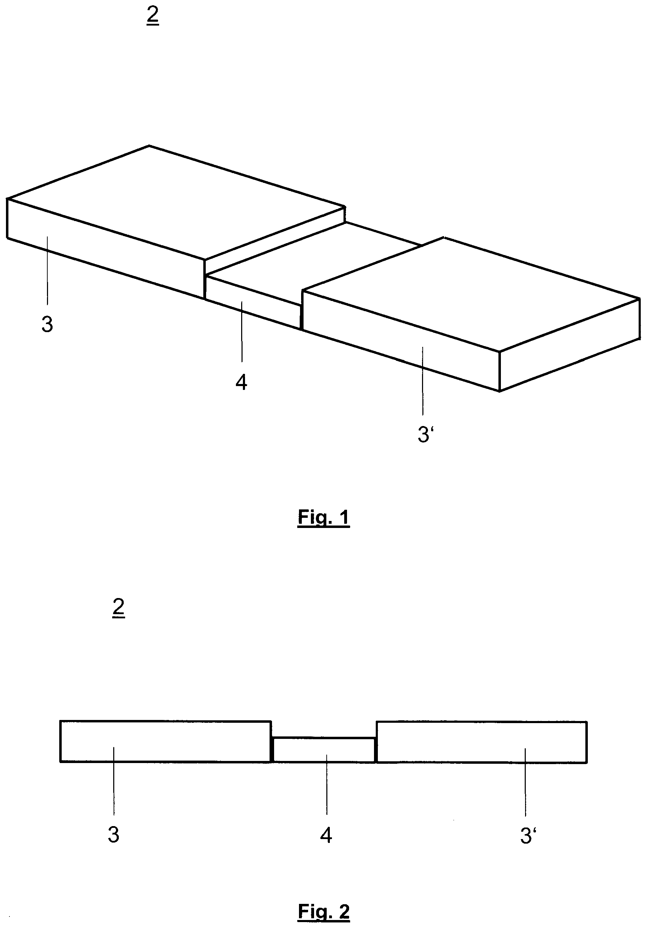

Fig. 1 zeigt eine Schrägansicht einer Widerstandsanordnung 2 noch ohne ein Kontaktelement. Die Widerstandsanordnung 2 weist zwei endständige Anschlusselemente 3, 3' und ein Widerstandselement 4 auf, welches zwischen den beiden Anschlusselementen 3, 3' positioniert ist. Die Anschlusselemente 3, 3' und das Widerstandselement 4 haben jeweils eine plattenförmige Form. Die Dicke des Widerstandselements 4 ist etwas geringer als die jeweilige Dicke der beiden Anschlusselemente 3, 3'. Die Widerstandsanordnung 2 kann an den beiden Anschlusselementen 3, 3' mit einem Stromkreis verbunden werden. Zu diesem Zweck können die beiden Anschlusselemente 3, 3' nicht dargestellte Verbindungsvorrichtungen aufweisen, beispielsweise Bohrungen. Diese Verbindungsvorrichtungen sind jeweils in dem Bereich der Anschlusselemente 3, 3' angebracht, der vom Widerstandselement 4 entfernt ist. Das Widerstandselement 4 befindet sich bezogen auf die Richtung des Stromflusses zwischen den Anschlusselementen 3, 3'. Bei Stromfluss fällt über dem Widerstandselement 4 eine elektrische Spannung ab, anhand derer die Stärke des durch die Widerstandsanordnung 2 fließenden Stroms ermittelt werden kann.

Fig. 2 zeigt eine Seitenansicht der Widerstandsanordnung 2 gemäß Fig. 1. Eine Widerstandsanordnung 2 wie in Figuren 1 und 2 dargestellt kann in bekannter Weise durch Längsnahtschweißen von drei Bändern zu einem Verbundmaterial und anschließendes Ablängen des geschweißten Verbundmaterials hergestellt werden.

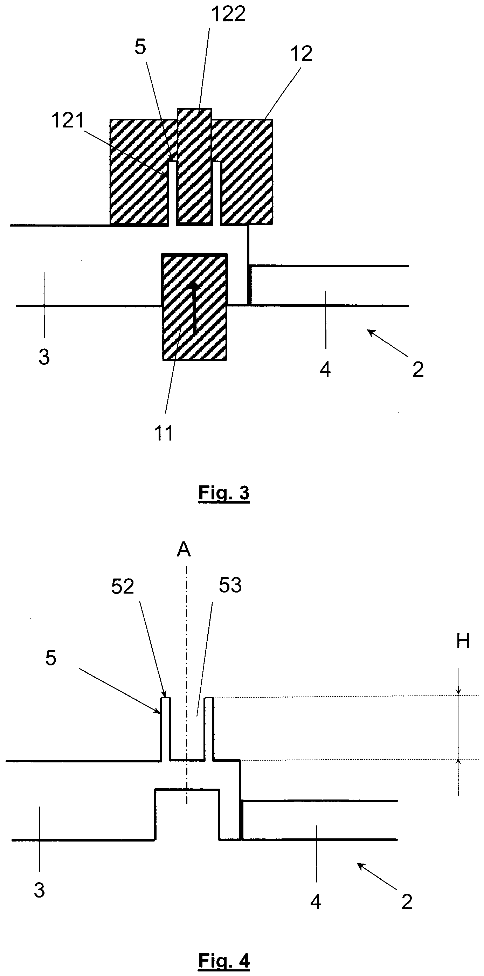

Fig. 3 zeigt in Schnittansicht einen vergrößerten Ausschnitt der Widerstandsanordnung 2 gemäß Fig. 1 und 2 bei Abschluss von Verfahrensschritt b). Auf der Oberseite des Anschlusselements 3 wurde eine Negativform 12 mit einer Aussparung 121 und einem in der Aussparung 121 angeordneten Innenwerkzeug 122 positioniert. Auf der Unterseite des Anschlusselements 3 ist ein Stempel 11 in das Material des Anschlusselements 3 eingedrungen, was durch den nach oben gerichteten Pfeil symbolisiert ist. Der Stempel 11 ist so positioniert, dass er der Aussparung 121 der Negativform 12 gegenüberliegt. Durch das Eindringen des Stempels 11 wurde Material des Anschlusselements 3 im Wesentlichen senkrecht zur Oberfläche des Anschlusselements 3 verformt und in den leeren Raum der Negativform 12 verlagert, welcher durch die Aussparung 121 und das Innenwerkzeug 122 definiert ist. Auf diese Weise wurde ein Werkstoffvorsprung geformt, der das Kontaktelement 5 bildet. Das Innenwerkzeug 122 bewirkt, dass das Kontaktelement 5 nach Entfernung des Innenwerkzeugs 122 einen einseitig offenen Hohlraum aufweist.

Fig. 4 zeigt in Schnittansicht einen vergrößerten Ausschnitt der Widerstandsanordnung 2 mit einem geformten Kontaktelement 5 nach Verfahrensschritt b). Der Stempel 11 und die Negativform 12 wurden entfernt. Um das Entfernen von Stempel 11 und Negativform 12 zu erleichtern, können der Stempel 11, die Aussparung 121 und das Innenwerkzeug 122 in der Negativform 12 jeweils eine Kontur mit Schrägen zur Entformung aufweisen. Dementsprechend können die geformten Kontaktelemente 5 ebenfalls eine Kontur mit Schrägen aufweisen. Der Winkel, den die Schrägen zur Entformung mit der Normalen auf die Oberfläche der Anschlusselemente 3 einschließen, beträgt typischerweise ungefähr 2°. Aufgrund dieser geringen Abweichung von der Normalen sind die Schrägen in den Figuren nicht explizit dargestellt.

Das Kontaktelement 5 weist eine Längsachse A auf, die senkrecht zur Oberfläche des Anschlusselements 3 orientiert ist. Ferner weist das Kontaktelement 5 eine Stirnseite 52 auf, die vom Anschlusselement 3 und somit von der Widerstandsanordnung 2 abgewandt ist. Ausgehend von dieser Stirnseite 52 erstreckt sich ein Hohlraum 53 entlang der Längsachse A des Kontaktelements 5. Im dargestellten Fall erstreckt sich dieser Hohlraum 53 ungefähr bis zur unverformten Oberfläche des Anschlusselements 3. Aus fertigungstechnischen Gründen kann es jedoch vorteilhaft sein, das Kontaktelement 5 so zu formen, dass sich der Hohlraum 53 weniger weit in das Kontaktelement 5 erstreckt oder alternativ, dass der Hohlraum 53 bis in das Material des Anschlusselements 3 hinein reicht. Durch den Hohlraum 53 hat das Kontaktelement 5 die Form einer Hülse, die auf einer Seite geschlossen und auf der anderen Seite offen ist. Die Höhe des Kontaktelements 5 ist mit dem Symbol H gekennzeichnet. Die Höhe H wird ausgehend von der unverformten Oberfläche des Anschlusselements 3 bis zur Stirnseite 52 des Kontaktelements 5 gemessen.

Das Kontaktelement 5 ist zum Abgreifen der über dem Widerstandselement 4 abfallenden elektrischen Spannung vorgesehen. Um Verfälschungen des Messwerts zu minimieren, wurde das Kontaktelement 5 so aus dem Anschlusselement 3 geformt, dass es nahe an der Verbindungsstelle zwischen dem Anschlusselement 3 und dem Widerstandselement 4 positioniert ist.

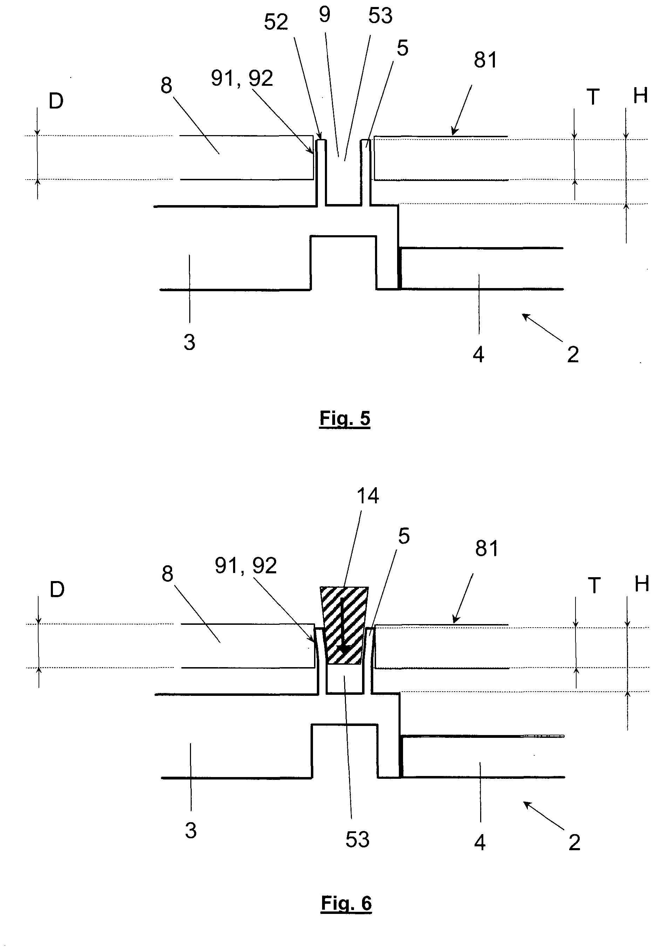

Fig. 5 zeigt in Schnittansicht den vergrößerten Ausschnitt der Widerstandsanordnung 2 gemäß Fig. 4 zusätzlich mit einer auf der Widerstandsanordnung 2 positionierten Leiterplatte 8 der Dicke D. Fig. 5 stellt somit die Widerstandsanordnung 2 und die Leiterplatte 8 nach Verfahrensschritt d) dar. Die Leiterplatte 8 weist eine Durchgangsbohrung 9 auf. Auf der inneren Oberfläche 91 der Durchgangsbohrung 9 der Leiterplatte 8 befindet sich elektrisch leitendes Material 92, das aus Gründen der Übersichtlichkeit nicht näher dargestellt ist. Die Leiterplatte 8 wurde so positioniert, dass das Kontaktelement 5 in die Durchgangsbohrung 9 bis zu einer Eindringtiefe T hineinragt. Im dargestellten Fall ist die Eindringtiefe T etwas geringer als die Dicke D der Leiterplatte 8, so dass die Stirnseite 52 des Kontaktelements 5 nicht bündig mit der Oberseite 81 der Leiterplatte 8 abschließt, sondern sich noch innerhalb der Durchgangsbohrung 9 befindet. Die Eindringtiefe T beträgt ungefähr 90 % der Dicke D der Leiterplatte 8. Die lichte Weite der Durchgangsbohrung 9 ist geringfügig größer als die äußere Abmessung des Kontaktelements 5. Im dargestellten Ausführungsbeispiel liegt die Leiterplatte 8 nicht unmittelbar auf dem Anschlusselement 3 auf, was beispielsweise durch nicht dargestellte Abstandshalter erreicht werden kann. Ein großer Abstand zwischen der Leiterplatte 8 und dem Widerstandselement 4 ist vorteilhaft, weil dadurch Wärme, die im Widerstandselement entsteht, schnell abgeführt werden kann. Auf der Leiterplatte 8 möglicherweise vorhandene, elektronische Bauteile sind aus Gründen der Übersichtlichkeit nicht dargestellt.

Fig. 6 zeigt in Schnittansicht den vergrößerten Ausschnitt der Widerstandsanordnung 2 während Verfahrensschritt e). Ein Aufweitmittel 14 mit konischer Form wird in Pfeilrichtung in den Hohlraum 53 des Kontaktelements 5 eingeführt. Die äußere Abmessung des Aufweitmittels 14 ist so gewählt, dass durch die konische Form des Aufweitmittels 14 das Material des Kontaktelements 5 in radialer Richtung nach außen, also zur inneren Oberfläche 91 der Durchgangsbohrung 9 hin, verlagert wird. Hierdurch kommt das Kontaktelement 5 unter Bildung einer elektrisch leitenden Verbindung mit dem elektrisch leitenden Material 92 auf der inneren Oberfläche 91 der Durchgangsbohrung 9 in Kontakt. Das in Fig. 6 dargestellte Aufweitmittel 14 kann ein Körper sein, der im Hohlraum 53 des Kontaktelements 5 verbleibt, oder es kann der Arbeitsbereich eines Werkzeugs sein, das nach dem Aufweiten wieder aus dem Hohlraum 53 des Kontaktelements 5 entfernt wird.

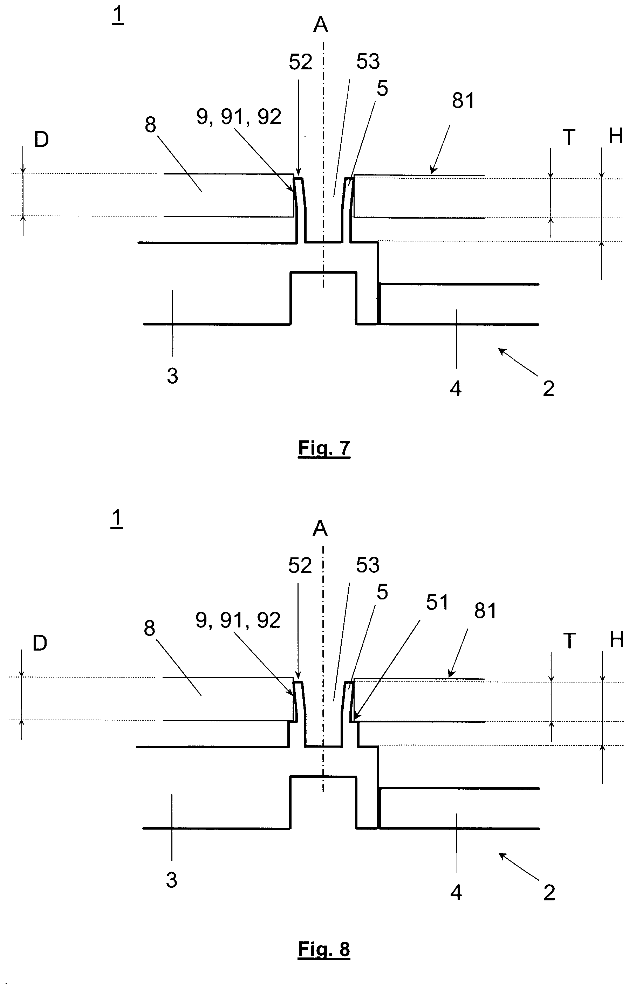

Fig. 7 zeigt in Schnittansicht den vergrößerten Ausschnitt der Widerstandsanordnung 2 gemäß Fig. 6 nach Entfernen des zum Aufweiten verwendeten Werkzeugs. Fig. 7 stellt somit gleichzeitig die Schnittansicht eines Teils einer Vorrichtung 1 zur Messung von Stromstärken mittels der Widerstandsanordnung 2 dar.

Fig. 8 zeigt als weiteres Ausführungsbeispiel die Schnittansicht eines Teils einer Vorrichtung 1 zur Messung von Stromstärken mit einer Widerstandsanordnung 2 und einer auf der Widerstandsanordnung 2 positionierten Leiterplatte 8. Das Kontaktelement 5 weist einen umlaufenden Absatz 51 auf, auf dem die Leiterplatte 8 aufliegt. Zu diesem Zweck ist das Kontaktelement 5 so gestaltet, dass die äußere Abmessung des Kontaktelements 5 in dem Teilbereich, der unmittelbar an das Anschlusselement 3 angrenzt, größer als die lichte Weite der Durchgangsbohrung 9 der Leiterplatte 8 ist. Somit liegt die Leiterplatte 8 auch ohne zusätzliche Abstandshalter weder auf dem Anschlusselement 3 noch auf dem Widerstandselement 4 auf. Bei der Formung des Kontaktelements 5 aus dem Material des Anschlusselements 3 wurde die Höhe des Absatzes 51 bereits berücksichtigt. Die Kontaktierung der Leiterplatte 8 durch das Kontaktelement 5 erfolgt in gleicher Weise wie bei dem in Fig. 6 dargestellten und im Zusammenhang mit Fig. 6 erläuterten Ausführungsbeispiel.

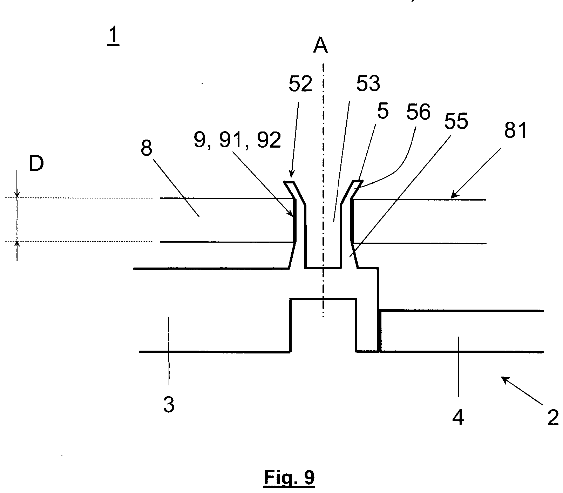

Fig. 9 zeigt als weiteres Ausführungsbeispiel die Schnittansicht eines Teils einer Vorrichtung 1 zur Messung von Stromstärken mit einer Widerstandsanordnung 2 und einer auf der Widerstandsanordnung 2 positionierten Leiterplatte 8. Das Kontaktelement 5 weist zwischen dem Anschlusselement 3 und der Leiterplatte 8 einen Abschnitt 55 mit einer konischen Außenkontur auf, der sich unmittelbar an die Leiterplatte 8 anschließt. Ferner weist das Kontaktelement 5 einen Überstand 56 über die Leiterplatte 8 auf. Im Bereich dieses Überstands 56 wurde das Kontaktelement 5 konisch aufgeweitet. Dadurch ragt das Kontaktelement 5 in lateraler Richtung über die Oberseite 81 der Leiterplatte 8. Durch das konische Aufweiten des Kontaktelements 5 im Bereich seines Überstands 56 wurde die Leiterplatte 8 in Richtung zum Anschlusselement 3 hinbewegt und somit auf den konischen Abschnitt 55 des Kontaktelements 5 zwischen der Leiterplatte 8 und dem Anschlusselement 3 gedrückt. Auf diese Weise wird die Leiterplatte 8 in Richtung der Längsachse A des Kontaktelements kraftschlüssig fixiert.

Aus Gründen der besseren Darstellbarkeit wurde die Erfindung in den Figuren 1 bis 9 exemplarisch anhand einer Widerstandsanordnung 2 erläutert, die lediglich ein Widerstandselement 4 und zwei endständige Anschlusselemente 3, 3' umfasst. Es ist auch möglich, das vorstehend beschriebene Verfahren auf Widerstandsanordnungen anzuwenden, die zwei oder mehr Widerstandselemente sowie mindestens ein weiteres, in Bezug auf einen möglichen Strompfad zwischen zwei Widerstandselementen angeordnetes Anschlusselement aufweisen. Die Widerstandsanordnung kann dabei so konfiguriert sein, dass durch mindestens zwei Widerstandselemente der gleiche Strom fließt, was eine redundante Strommessung ermöglicht, oder dass durch mindestens zwei Widerstandselemente verschiedene Ströme fließen, was die Messung von Teilströmen ermöglicht. Das anhand der vorstehenden Beschreibung, anhand der Figuren 1 bis 9 und anhand der Ausführungsbeispiele erläuterte Verfahren zur Formung von Kontaktelementen 5 und zur Herstellung einer elektrischen Verbindung mit einer Leiterplatte 8 kann in diesen Fällen auch zur Formung von einem oder mehreren Kontaktelementen 5 aus dem Material eines zwischen zwei Widerstandselementen angeordneten Anschlusselements verwendet werden.

### Bezugszeichenliste

- 1: Vorrichtung
- 2: Widerstandsanordnung
- 3, 3': Anschlusselement
- 4: Widerstandselement
- 5: Kontaktelement
- 51: Absatz
- 52: Stirnseite
- 53: Hohlraum
- 55: Abschnitt
- 56: Überstand
- 8: Leiterplatte
- 81: Oberseite
- 9: Durchgangsbohrung
- 91: innere Oberfläche
- 92: elektrisch leitendes Material
- 11: Stempel
- 12: Negativform
- 121: Aussparung
- 122: Innenwerkzeug
- 14: Aufweitmittel

- A: Längsachse
- H: Höhe
- T: Eindringtiefe
- D: Dicke

## Patentansprüche

1. Verfahren zur Herstellung einer Vorrichtung (1) zur Messung der Stärke eines elektrischen Stroms mittels einer Widerstandsanordnung (2), wobei das Verfahren folgende Schritte umfasst:
a) Bereitstellen einer Widerstandsanordnung (2) umfassend mindestens zwei Anschlusselemente (3, 3') und mindestens ein in Bezug auf die Richtung des elektrischen Stroms zwischen den Anschlusselementen (3, 3') angeordnetes Widerstandselement (4), wobei das mindestens eine Widerstandselement (4) einerseits und die Anschlusselemente (3, 3') andererseits aus unterschiedlichen, elektrisch leitenden Materialien bestehen,
b) Herausformen mindestens eines Kontaktelements (5) aus dem Material mindestens eines Anschlusselements (3, 3') oder aus dem Material des Widerstandselements (4), so dass das Kontaktelement (5) monolithisch mit dem Anschlusselement (3, 3') beziehungsweise mit dem Widerstandselement (4) verbunden ist,_wobei das Kontaktelement (5) eine Längsachse (A) aufweist, durch die eine axiale Richtung und eine hierzu senkrechte radiale Richtung definiert werden, und wobei das Kontaktelement (5) so geformt wird, dass es eine von der Widerstandsanordnung (2) abgewandte Stirnseite (52) und einen Hohlraum (53) aufweist, der auf der von der Widerstandsanordnung (2) abgewandten Stirnseite (52) des Kontaktelements (5) offen ist,
c) Bereitstellen einer Leiterplatte (8), welche mindestens eine Durchgangsbohrung (9) mit einer inneren Oberfläche (91) aufweist, auf der sich elektrisch leitendes Material (92) befindet,
d) Positionieren der Leiterplatte (8) auf der Widerstandsanordnung (2) derart, dass die Leiterplatte (8) eine von der Widerstandsanordnung (2) abgewandte Oberseite (81) aufweist und dass das mindestens eine Kontaktelement (5) in die Durchgangsbohrung (9) zumindest hineinragt,
e) Aufweiten des Kontaktelements (5) in radialer Richtung mittels eines Aufweitmittels (14), das in axialer Richtung in den Hohlraum (53) des Kontaktelements (5) bis in den Bereich der Durchgangsbohrung (9) der Leiterplatte (8) eingeführt wird, so dass eine elektrisch leitende Verbindung zwischen dem Kontaktelement (5) und dem elektrisch leitenden Material (92) auf der inneren Oberfläche (91) der Durchgangsbohrung (9) hergestellt wird.

2. Verfahren nach Anspruch 1, **dadurch gekennzeichnet, dass** das Aufweitmittel (14) so gestaltet ist, dass das Aufweiten des Kontaktelements (5) durch das Einführen des Aufweitmittels (14) erfolgt.

3. Verfahren nach Anspruch 1, **dadurch gekennzeichnet, dass** das Aufweitmittel (14) so gestaltet ist, dass das Aufweiten des Kontaktelements (5) nach dem Einführen des Aufweitmittels (14) erfolgt.

4. Verfahren nach einem der Ansprüche 1 bis 3, **dadurch gekennzeichnet, dass** durch das Aufweiten in Verfahrensschritt e) eine kraftschlüssige Verbindung zwischen der inneren Oberfläche (91) der Durchgangsbohrung (9) der Leiterplatte (8) und dem Kontaktelement (5) hergestellt wird.

5. Verfahren nach einem der Ansprüche 1 bis 4, **dadurch gekennzeichnet, dass** das Kontaktelement (5) eine Höhe (H) aufweist, die so gewählt ist, dass nach dem Positionieren der Leiterplatte (8) die von der Widerstandsanordnung (2) abgewandte Stirnseite (52) des Kontaktelements (5) sich innerhalb der Durchgangsbohrung (9) der Leiterplatte (8) befindet oder mit der Oberseite (81) der Leiterplatte (8) bündig abschließt.

6. Verfahren nach einem der Ansprüche 1 bis 5, **dadurch gekennzeichnet, dass** das Formen des Kontaktelements (5) in Verfahrensschritt b) durch einen Prägeschritt oder durch Fließpressen erfolgt.

7. Verfahren nach Anspruch 6, **dadurch gekennzeichnet, dass** zur Formgebung des Kontaktelements (5) eine Negativform (12) mit mindestens einer der äußeren Kontur des Kontaktelements (5) entsprechenden Aussparung (121) und mindestens einem in der Aussparung (121) positionierten Innenwerkzeug (122) zur Formung des Hohlraums (53) verwendet wird und dass während Verfahrensschritt b) das Innenwerkzeug (122) in Richtung der Längsachse (A) des Kontaktelements (5) relativ zur Aussparung (121) bewegt wird.

8. Verfahren nach einem der vorstehenden Ansprüche, **dadurch gekennzeichnet, dass** das Aufweiten des Kontaktelements (5) in Verfahrensschritt e) durch Erwärmen des Materials des Kontaktelements (5) mittels Ultraschall oder mittels eines Lasers unterstützt wird.

9. Vorrichtung (1) zur Messung der Stärke eines elektrischen Stroms umfassend eine Widerstandsanordnung (2) und eine mit der Widerstandsanordnung (2) mechanisch und elektrisch verbundene Leiterplatte (8), wobei die Widerstandsanordnung (2) mindestens zwei Anschlusselemente (3, 3') und mindestens ein in Bezug auf die Richtung des Stroms zwischen den Anschlusselementen (3, 3') angeordnetes Widerstandselement (4) umfasst, wobei das mindestens eine Widerstandselement (4) einerseits und die Anschlusselemente (3, 3') andererseits aus unterschiedlichen, elektrisch leitenden Materialien bestehen,
und wobei die Leiterplatte (8) mindestens eine Durchgangsbohrung (9) mit einer inneren Oberfläche (91) aufweist, auf der sich elektrisch leitendes Material (92) befindet,
wobei die Widerstandsanordnung (2) mindestens ein Kontaktelement (5) mit einer Längsachse (A) aufweist, das monolithisch mit einem der Anschlusselemente (3, 3') verbunden und aus dem Material des Anschlusselements (3, 3') herausgearbeitet ist oder das monolithisch mit dem Widerstandselement (4) verbunden und aus dem Material des Widerstandselements (4) herausgearbeitet ist,
und durch welches die Widerstandsanordnung (2) mit der Leiterplatte (8) elektrisch leitend und mechanisch verbunden ist, indem das Kontaktelement (5) in die Durchgangsbohrung (9) der Leiterplatte (8) zumindest hineinragt und mit dem elektrisch leitenden Material (92) auf der inneren Oberfläche (91) der Durchgangsbohrung (9) kraftschlüssig verbunden ist,
wobei das Kontaktelement (5) eine von der Widerstandsanordnung (2) abgewandten Stirnseite (52) und einen Hohlraum (53) aufweist, der auf der von der Widerstandsanordnung (2) abgewandten Stirnseite (52) des Kontaktelements (5) offen ist,
**dadurch gekennzeichnet, dass**
das Kontaktelement (5) auf seiner Innenseite am Übergang von seiner Stirnseite (52) zum Hohlraum (53) eine konische Kontur aufweist, die sich bis in den Bereich der Durchgangsbohrung (9) der Leiterplatte (8) erstreckt.

10. Vorrichtung (1) nach Anspruch 9, **dadurch gekennzeichnet, dass** das Kontaktelement (5) eine Höhe (H) aufweist, die so gewählt ist, dass die von der Widerstandsanordnung (2) abgewandte Stirnseite (52) des Kontaktelements (5) sich innerhalb der Durchgangsbohrung (9) der Leiterplatte (8) befindet oder mit der Oberseite (81) der Leiterplatte (8) bündig abschließt.

11. Vorrichtung (1) nach Anspruch 9, **dadurch gekennzeichnet, dass** das Kontaktelement (5) auf der von der Widerstandsanordnung (2) abgewandten Seite der Leiterplatte (8) einen Überstand (56) über die Leiterplatte (8) aufweist und im Bereich dieses Überstands (56) zur Fixierung der Leiterplatte (8) lateral verbreitet ist.

12. Vorrichtung (1) nach Anspruch 11, **dadurch gekennzeichnet, dass** das Kontaktelement (5) zwischen dem Anschlusselement (3, 3') und der Leiterplatte (8) einen Abschnitt (55) mit einer konischen Außenkontur aufweist, so dass sich die Querschnittsfläche des Kontaktelements (5) zum Anschlusselement (3, 3') hin vergrößert.

13. Vorrichtung (1) nach einem der Ansprüche 9 bis 12, **dadurch gekennzeichnet, dass** das mindestens eine Kontaktelement (5) einen Absatz (51) aufweist, auf dem die Leiterplatte (8) in einer Weise aufliegt, dass die Leiterplatte (8) von der Widerstandsanordnung (2) beabstandet ist.

14. Vorrichtung (1) nach einem der Ansprüche 9 bis 13, **dadurch gekennzeichnet, dass** das mindestens eine Kontaktelement (5) eine Oberfläche mit einer metallischen Beschichtung, insbesondere einer zinn-, silber- oder nickelhaltigen Beschichtung, aufweist.

## Claims

1. Method for producing an apparatus (1) for measuring the strength of an electrical current by means of a resistor arrangement (2), wherein the method comprises the following steps:
a) providing a resistor arrangement (2) comprising at least two connection elements (3, 3') and at least one resistance element (4) which is arranged with respect to the direction of the electrical current between the connection elements (3, 3'), wherein the at least one resistance element (4) on the one hand and the connection elements (3, 3') on the other hand comprise different electrically conductive materials,
b) forming at least one contact element from the material of at least one connection element (3, 3') or from the material of the resistance element (4) so that the contact element (5) is monolithically connected to the connection element (3, 3') or to the resistance element (4), wherein the contact element (5) has a longitudinal axis (A) by means of which an axial direction and a radial direction which is perpendicular thereto are defined, and wherein the contact element (5) is formed in such a manner that it has an end face (52) which faces away from the resistor arrangement (2) and a hollow space (53) which is open at the end face (52) of the contact element (4) facing away from the resistor arrangement (2),
c) providing a printed circuit board (8) which has at least one through-hole (9) having an inner surface (91) on which electrically conductive material (92) is located,
d) positioning the printed circuit board (8) on the resistor arrangement (2) in such a manner that the printed circuit board (8) has an upper side (81) which faces away from the resistor arrangement (2) and the at least one contact element (5) protrudes at least into the through-hole (9),
e) expanding the contact element (5) in a radial direction by means of an expansion means (14) which is introduced in an axial direction into the hollow space (53) of the contact element (5) as far as the region of the through-hole (9) of the printed circuit board (8) so that an electrically conductive connection between the contact element (5) and the electrically conductive material (92) is produced on the inner surface (91) of the through-hole (9).

2. Method according to claim 1, **characterised in that** the expansion means (14) is configured in such a manner that the expansion of the contact element (5) is carried out by introducing the expansion means (14).

3. Method according to claim 1, **characterised in that** the expansion means (14) is configured in such a manner that the expansion of the contact element (5) is carried out after the introduction of the expansion means (14).

4. Method according to any one of claims 1 to 3, **characterised in that**, as a result of the expansion in the method step e), a non-positive-locking connection is produced between the inner surface (91) of the through-hole (9) of the printed circuit board (8) and the contact element (5).

5. Method according to any one of claims 1 to 4, **characterised in that** the contact element (5) has a height (H) which is selected in such a manner that, after the positioning of the printed circuit board (8), the end face (52) of the contact element (5) facing away from the resistor arrangement (2) is located inside the through-hole (9) of the printed circuit board (8) or terminates flush with the upper side (81) of the printed circuit board (8).

6. Method according to any one of claims 1 to 5, **characterised in that** the shaping of the contact element (5) is carried out in method step b) by means of a stamping step or by means of extrusion.

7. Method according to claim 6, **characterised in that** in order to shape the contact element (5) a negative mould (12) having at least one recess (121) which corresponds to the outer contour of the contact element (5) and at least one inner tool (122) which is positioned in the recess (121) is used to shape the hollow space (53) and **in that** during method step b) the inner tool (122) is moved in the direction of the longitudinal axis (A) of the contact element (5) relative to the recess (121).

8. Method according to any one of the preceding claims, **characterised in that** the expansion of the contact element (5) in method step e) is supported by heating the material of the contact element (5) by means of ultrasound or by means of a laser.

9. Apparatus (1) for measuring the strength of an electrical current comprising a resistor arrangement (2) and a printed circuit board (8) which is mechanically and electrically connected to the resistor arrangement (2), wherein the resistor arrangement (2) comprises at least two connection elements (3, 3') and at least one resistance element (4) which is arranged with respect to the direction of the current between the connection elements (3, 3'), wherein the at least one resistance element (4) on the one hand and the connection elements (3, 3') on the other hand comprise different electrically conductive materials,
and wherein the printed circuit board (8) has at least one through- hole (9) having an inner surface (91) on which electrically conductive material (92) is located,
wherein the resistor arrangement (2) has at least one contact element (5) having a longitudinal axis (A) which is monolithically connected to one of the connection elements (3, 3') and is formed from the material of the connection element (3, 3') or which is monolithically connected to the resistance element (4) and formed from the material of the resistance element (4),
and by means of which the resistor arrangement (2) is electrically conductively and mechanically connected to the printed circuit board (8) by the contact element (5) protruding at least into the through-hole (9) of the printed circuit board (8) and being connected in a non-positive-locking manner to the electrically conductive material (92) on the inner surface (91) of the through-hole (9),
wherein the contact element (5) has an end face (52) which faces away from the resistor arrangement (2) and a hollow space (53) which is open at the end face (52) of the contact element (5) facing away from the resistor arrangement (2),
**characterised in that**
the contact element (5) has at the inner side thereof at the transition from the end face (52) thereof to the hollow space (53) a conical contour which extends into the region of the through-hole (9) of the printed circuit board (8).

10. Apparatus (1) according to claim 9, **characterised in that** the contact element (5) has a height (H) which is selected in such a manner that the end face (52) of the contact element (5) facing away from the resistor arrangement (2) is located inside the through-hole (9) of the printed circuit board (8) or terminates flush with the upper side (81) of the printed circuit board (8).

11. Apparatus (1) according to claim 9, **characterised in that** the contact element (5) has at the side of the printed circuit board (8) facing away from the resistor arrangement (2) an overhang (56) over the printed circuit board (8) and is laterally widened in the region of this overhang (56) in order to fix the printed circuit board (8).

12. Apparatus (1) according to claim 11, **characterised in that** the contact element (5) has between the connection element (3, 3') and the printed circuit board (8) a portion (55) having a conical outer contour so that the cross sectional surface-area of the contact element (5) increases in the direction towards the connection element (3, 3').

13. Apparatus (1) according to any one of claims 9 to 12, **characterised in that** the at least one contact element (5) has a shoulder (51) on which the printed circuit board (8) is positioned in such a manner that the printed circuit board (8) is spaced apart from the resistor arrangement (2).

14. Apparatus (1) according to any one of claims 9 to 13, **characterised in that** the at least one contact element (5) has a surface having a metal coating, in particular a tin-containing, silver-containing or nickel-containing coating.

## Revendications

1. Procédé de fabrication d'un dispositif (1), pour la mesure de l'intensité d'un courant électrique au moins d'un dispositif à résistance (2), dans lequel le procédé comprend les étapes suivantes :
a) mise à disposition d'un dispositif à résistance (2) comprenant au moins deux éléments de raccordement (3, 3') et au moins un élément de résistance (4) disposé entre les éléments de raccordement (3, 3') par rapport au sens du courant électrique, dans lequel l'au moins un élément de résistance (4) d'une part et les éléments de raccordement (3, 3') d'autre part sont constitués de matériaux électro-conducteurs différents,
b) formage d'au moins élément de contact (5) à partir du matériau d'au moins un élément de raccordement (3, 3') ou du matériau de l'élément de résistance (4), de sorte que l'élément de contact (5) est relié de manière monolithique avec l'élément de raccordement (3, 3') respectivement avec l'élément de résistance (4), dans lequel l'élément de contact (5) présente un axe longitudinal (A) grâce auquel une direction axiale et une direction radiale, perpendiculaire à celle-ci, sont définies et dans lequel l'élément de contact (5) est formé de sorte qu'il présente une face frontale (52) opposée au dispositif à résistance (2) et une cavité (53) qui est ouverte sur la face frontale (52) de l'élément de contact (5) opposée au dispositif à résistance (2),
c) mise à disposition d'un circuit imprimé (8) qui comprend au moins un perçage de passage (9) avec une surface interne (91) sur laquelle se trouve un matériau électro-conducteur (92),
d) positionnement du circuit imprimé (8) sur le dispositif à résistance (2) de sorte que le circuit imprimé (8) présente une face supérieure (81) opposée au dispositif à résistance (2) et que l'au moins un élément de contact (5) dépasse au moins dans le perçage de passage (9),
e) élargissement de l'élément de contact (5) dans la direction radiale à l'aide d'un moyen d'élargissement (14), qui est introduit dans la direction axiale dans la cavité (53) de l'élément de contact (5) jusqu'au niveau du perçage de passage (9) du circuit imprimé (8), de sorte qu'une liaison électro-conductrice est établie entre l'élément de contact (5) et le matériau électro-conducteur (92) sur la surface interne (91) du perçage de passage (9).

2. Procédé selon la revendication 1, **caractérisé en ce que** le moyen d'élargissement (14) est conçu de sorte que l'élargissement de l'élément de contact (5) a lieu grâce à l'introduction du moyen d'élargissement (14).

3. Procédé selon la revendication 1, **caractérisé en ce que** le moyen d'élargissement (14) est conçu de sorte que l'élargissement de l'élément de contact (5) a lieu après l'introduction du moyen d'élargissement (14).

4. Procédé selon l'une des revendications 1 à 3, **caractérisé en ce que** l'élargissement à l'étape e) permet d'établir une liaison par force entre la surface interne (91) du perçage de passage (9) du circuit imprimé (8) et l'élément de contact (5).

5. Procédé selon l'une des revendications 1 à 4, **caractérisé en ce que** l'élément de contact (5) présente une hauteur (H) qui est choisie de sorte que, après le positionnement du circuit imprimé (8), la face frontale (52), opposée au dispositif à résistance (2), de l'élément de contact (5), se trouve à l'intérieur du perçage de passage (9) du circuit imprimé (8) ou se termine en affleurement avec la face supérieure (81) du circuit imprimé (8).

6. Procédé selon l'une des revendications 1 à 5, **caractérisé en ce que** le formage de l'élément de contact (5) à l'étape b) est effectué à l'aide d'une étape d'estampage ou par fluage.

7. Procédé selon la revendication 6, **caractérisé en ce que**, pour le formage de l'élément de contact (5), un moule négatif (12), avec au moins un évidement (121) correspondant au contour externe de l'élément de contact (5) et au moins un outil interne (122) positionné dans l'évidement (121), est utilisé pour le formage de la cavité (53) et **en ce que**, pendant l'étape b), l'outil interne (122) est déplacé en direction de l'axe longitudinal (A) de l'élément de contact (5) par rapport à l'évidement (121).

8. Procédé selon l'une des revendications précédentes, **caractérisé en ce que** l'élargissement de l'élément de contact (5) à l'étape e) est facilitée par le chauffage du matériau de l'élément de contact (5) par des ultrasons ou au moyen d'un laser.

9. Dispositif (1) pour la mesure de l'intensité d'un courant électrique comprenant un dispositif à résistance (2) et un circuit imprimé (8) relié mécaniquement et électriquement avec le dispositif à résistance (2), dans lequel le dispositif à résistance (2) comprend au moins deux éléments de raccordement (3, 3') et au moins un élément de résistance (4) disposé entre les éléments de raccordement (3, 3') par rapport au sens du courant, dans lequel l'au moins un élément de résistance (4) d'une part et les éléments de raccordement (3, 3') d'autre part sont constitués de matériaux électro-conducteurs différents,
et dans lequel le circuit imprimé (8) comprend au moins un perçage de passage (9) avec une surface interne (91) sur laquelle se trouve un matériau électro-conducteur (92),
dans lequel le dispositif à résistance (2) comprend au moins un élément de contact (5) avec un axe longitudinal (A), qui est relié de manière monolithique avec un des éléments de raccordement (3, 3') et qui est constitué du matériau de l'élément de raccordement (3, 3') ou qui est relié de manière monolithique avec l'élément de résistance (4) et qui est constitué du matériau de l'élément de résistance (4),
et grâce auquel le dispositif à résistance (2) est relié mécaniquement et électriquement avec le circuit imprimé (8), grâce au fait que l'élément de contact (5) dépasse au moins dans le perçage de passage (9) du circuit imprimé (8) et est relié par force avec le matériau électro-conducteur (92) sur la surface interne (91) du perçage de passage (9),
dans lequel l'élément de contact (5) présente une face frontale (52) opposée au dispositif à résistance (2) et une cavité (53) qui est ouverte sur la face frontale (52), opposée au dispositif à résistance (2), de l'élément de contact (5),
**caractérisé en ce que**
l'élément de contact (5) présente, sur sa face interne, au niveau de la transition entre sa face interne (52) et la cavité (53), un contour conique qui s'étend jusqu'au niveau du perçage de passage (9) du circuit imprimé (8).

10. Dispositif (1) selon la revendication 9, **caractérisé en ce que** l'élément de contact (5) présente une hauteur (H) qui est choisie de façon à ce que la face frontale (52), opposée au dispositif à résistance (2), de l'élément de contact (5) se trouve à l'intérieur du perçage de passage (9) du circuit imprimé (8) ou se termine en affleurement avec la face supérieure (81) du circuit imprimé (8).

11. Dispositif (1) selon la revendication 9, **caractérisé en ce que** l'élément de contact (5) présente, sur la face, opposée au dispositif à résistance (2), du circuit imprimé (8), un débord (56) par rapport au circuit imprimé (8) et s'élargit latéralement au niveau de ce débord (56) pour la fixation du circuit imprimé (8).

12. Dispositif (1) selon la revendication 11, **caractérisé en ce que** l'élément de contact (5) présente, entre l'élément de raccordement (3, 3') et le circuit imprimé (8), une portion (55) avec un contour externe conique, de sorte que la surface de section transversale de l'élément de contact (5) augmente en direction de l'élément de raccordement (3, 3').

13. Dispositif (1) selon l'une des revendications 9 à 12, **caractérisé en ce que** l'au moins un élément de raccordement (5) présente un épaulement (51) sur lequel s'appuie le circuit imprimé (8), de sorte que le circuit imprimé (8) est distant du dispositif à résistance (2).

14. Dispositif (1) selon l'une des revendications 9 à 13, **caractérisé en ce que** l'au moins un élément de raccordement (5) présente une surface avec un revêtement métallique, plus particulièrement un revêtement contenant de l'étain, de l'argent ou du nickel.
